# EUROPEAN PATENT APPLICATION

(11) **EP 2 157 626 A2**
(43) Date of publication of application: **24.02.2010**
(21) Application number: 09251820.8
(22) Date of filing: 17.07.2009
(51) Int. Cl.: H01L 41/187

(54) **Piezoelectric/electrostrictive ceramics sintered body and piezoelectric/electrostrictive device using the same**

(30) Priority: 28.07.2008 JP 2008192947; 02.07.2009 JP 2009157802
(71) Applicant: NGK Insulators, Ltd., Aichi Pref. 467-8530 (JP)
(72) Inventor: Kaigawa, Kazuyuki, Nagoya City Aichi-ken, 467-8530 (JP); Tanaka, Ritsu, Nagoya City Aichi-ken, 467-8530 (JP); Yamaguchi, Hirofumi, Nagoya City Aichi-ken, 467-8530 (JP)
(74) Representative: Naylor, Matthew John

(57) **Abstract**

There is disclosed a piezoelectric/electrostrictive ceramics which is a sintered body having a structure where a matrix and a filler are brought into a composite, the matrix is made of an alkali niobate-based piezoelectric/electrostrictive material , which includes a large number of grains combined with one another, including a perovskite type oxide, which includes at least one element selected from the group consisting of Li, Na and K as an A site constituent element and Nb as a B site constituent element, as a main crystal phase, the filler is made of a material (with the proviso that an alkali niobate-based material is excluded) having a thermal expansion coefficient smaller than that of the alkali niobate-based piezoelectric/electrostrictive material, and the volume fraction of the filler with respect to the total volume of the matrix and the filler is 0.5 vol% or more and below 10 vol%.

## Description

### BACKGROUND OF THE INVENTION

### 1. Field of the Invention

The present invention relates to an alkali niobate-based piezoelectric/electrostrictive ceramics sintered body used in an actuator or a sensor, and a piezoelectric/electrostrictive device using the same.

### 2. Description of the Related Art

A piezoelectric actuator has an advantage that the actuator can control displacement precisely on the order of sub-microns. In particular, the piezoelectric actuator using a piezoelectric/electrostrictive ceramics sintered body as a piezoelectric/electrostrictive body (a piezoelectric/electrostrictive device) precisely controls the displacement, and additionally has advantages such as an electromechanical conversion efficiency being high, a generation force being large, a response speed being high, a durability being high and a power consumption being small. Therefore, by using these advantages, the actuator is employed in a head of an ink jet printer, an injector of a diesel engine or the like.

As such a piezoelectric/electrostrictive ceramics sintered body for the piezoelectric actuator, heretofore, a lead zirconate titanate {Pb(Zr, Ti)O₃, PZT} based material has been used, but the influence of the solute of lead from the sintered body on the global environment has been strongly feared, and hence an alkali niobate-based material is also investigated (e.g., see JP-A-2006-28001 (Patent Document 1), M. Matsubara et. al., Jpn. J. Appl. Phys. 44(2005) pp. 6136 to 6142 (Non-Patent Document 1), E. Hollenstein et. al., Appl. Phys. Lett. 87(2005)182905 (Non-Patent Document 2), Y. Guo et. al., App. Phys. Lett. 85(2004)4121 (Non-Patent Document 3), and Y. Saito et. al., Nature 432, 84 to 87(2004) (Non-Patent Document 4)).

It is known that in the PZT based material as the typical piezoelectric/electrostrictive ceramics sintered body, piezoelectric characteristics become high in a phase boundary. The phase boundary is a state in which two or more crystal phases having the same composition but having different crystal systems are mixedly present. For example, in the vicinity of Zr = Ti = 0.5, there is a state (the phase boundary) in which a tetragonal system and a rhombohedron system coexist, and the piezoelectric characteristics become high.

On the other hand, it is considered that in the alkali niobate-based piezoelectric/electrostrictive ceramics sintered body, the characteristics become high in a phase boundary between the tetragonal system and an orthorhombic system. When an A site contains only K and Na, the temperature of the phase boundary between the tetragonal system and the orthorhombic system is 200°C or more, and hence the characteristics in the vicinity of room temperature are low. However, Li is replaced with the A site to lower the phase boundary temperature, and the characteristics in the vicinity of the room temperature become high (see Non-Patent Document 3). After reporting this investigation, the composition including Li has become a mainstream. It is reported in an analysis using X-ray diffraction that the crystal system of a perovskite type oxide as the main crystal phase of the alkali niobate-based piezoelectric/electrostrictive ceramics sintered body is the tetragonal system, the orthorhombic system or a mixed system of the tetragonal system and the orthorhombic system.

Moreover, as the background of such a stream of technologies, heretofore, approaches such as the increase of denseness (e.g., see Non-Patent Document 1), element replacement (e.g., see Non-Patent Document 3) and an orientation structure (e.g., see Non-Patent Document 4) have been made in order to improve electric characteristics.

### SUMMARY OF THE INVENTION

However, in a conventional alkali niobate-based piezoelectric/electrostrictive ceramics sintered body, for example, electric-field-induced strain S4000 does not necessarily suffice, and the alkali niobate-based piezoelectric/electrostrictive ceramics sintered body for further improving electric characteristics such as the electric-field-induced strain are demanded. The present invention has been developed in view of such a situation, and an object thereof is to find a new index or item which can be a factor for improving characteristics and to provide an alkali niobate-based piezoelectric/electrostrictive ceramics sintered body for improving electric characteristics based on the new index or item.

As a result of repeated investigations, it has been found that when the composite material of the piezoelectric/electrostrictive ceramics sintered body (the composite material or the composite sintered body) is used and the material of the composite sintered body is provided with a thermal expansion difference to control stress in gain boundaries or in grains, electric characteristics can be improved, and the present invention has been completed as follows.

That is, according to the present invention, there is provided a piezoelectric/electrostrictive ceramics sintered body comprising a matrix and a filler and having a structure in which the matrix and the filler are brought into a composite, wherein the matrix is made of an alkali niobate-based piezoelectric/electrostrictive material, which includes a large number of grains combined with one another, including a perovskite type oxide, which includes at least one element selected from the group consisting of Li, Na and K as an A site constituent element and Nb as a B site constituent element, as a main crystal phase, the filler is made of a material (with the proviso that an alkali niobate-based material is excluded) having a thermal expansion coefficient smaller than that of the alkali niobate-based piezoelectric/electrostrictive material, and the volume fraction of the filler with respect to the total volume of the matrix and the filler is 0.5 vol% or more and below 10 vol%. It is to be noted that when the piezoelectric/electrostrictive ceramics sintered body has pore portions, the volume of the pore portions is excluded from "the total volume of the matrix and the filler".

In the piezoelectric/electrostrictive ceramics sintered body according to the present invention, the volume fraction of the filler is preferably 0.5 vol% or more and below 10 vol%, further preferably 1.5 vol% or more and 5 vol% or less. Moreover, in the piezoelectric/electrostrictive ceramics sintered body according to the present invention, the perovskite type oxide preferably further includes at least one of Ta and Sb as the B site constituent element.

Moreover, in the piezoelectric/electrostrictive ceramics sintered body according to the present invention, in Raman spectrum of the v1 symmetric stretching mode of the alkali niobate-based piezoelectric/electrostrictive material obtained when the matrix is subjected to Raman spectrometry, the spectrum wave number shifts to high wave side with exceeding 3 cm⁻¹ in grains as compared with grain boundaries. "The spectrum wave number" mentioned herein is the wave number of a peak top at which the intensity of the Raman spectrum becomes highest.

In the piezoelectric/electrostrictive ceramics sintered body according to the present invention, as compared with the grain boundaries, a region in the grains in which the spectrum wave number shifts to the high wave side with exceeding 3 cm⁻¹ is present as much as 10% or more and 50% or less in terms of area, further preferably 15% or more and 50% or less, especially preferably 20% or more and 50% or less.

In the piezoelectric/electrostrictive ceramics sintered body according to the present invention, the material of the filler is preferably at least one selected from the group consisting of molybdenum oxide, niobium oxide, tin oxide, tungsten oxide and aluminum oxide.

The matrix of the piezoelectric/electrostrictive ceramics sintered body according to the present invention is made of the alkali niobate-based piezoelectric/electrostrictive material, which includes a large number of grains combined with one another, including the perovskite type oxide represented by a composition formula: ABO₃ (A is at least one element selected from the group consisting of Li, Na and K, and B is Nb) as the main crystal phase. In other words, the matrix of the piezoelectric/electrostrictive ceramics sintered body according to the present invention is made of the perovskite type oxide including at least one element selected from the group consisting of Li, Na and K in an A site, and including Nb in a B site (preferably further including at least one of Ta and Sb).

Next, according to the present invention, there is provided a piezoelectric/electrostrictive device comprising: a film-like piezoelectric/electrostrictive body made of one of the above piezoelectric/electrostrictive ceramics sintered bodies; a pair of electrodes arranged so as to sandwich the piezoelectric/electrostrictive body therebetween; and a substrate joined to one of the surfaces of the pair of electrodes.

In the piezoelectric/electrostrictive device according to the present invention, the material of the substrate is preferably zirconium oxide (zirconia) or a metal.

From the viewpoints of a thermal resistance, a chemical stability and insulating properties, zirconium oxide is preferably stabilized. Other examples of the material of the substrate include at least one ceramic material selected from the group consisting of aluminum oxide, magnesium oxide, mullite, aluminum nitride, silicon nitride and glass.

Examples of the material of the electrodes include at least one metal selected from the group consisting of Pt, Pd, Rh, Au, Ag and an alloy of them. Above all, from a viewpoint that the thermal resistance is high during the firing of the piezoelectric/electrostrictive body, platinum or an alloy including platinum as a main component is preferable. Moreover, from a viewpoint that the piezoelectric/electrostrictive body can be formed at a lower firing temperature, an alloy such as Ag-Pd can preferably be used.

The piezoelectric/electrostrictive ceramics sintered body according to the present invention is the sintered body having the structure in which the matrix and the filler are brought into a composite, and the matrix is made of the alkali niobate-based piezoelectric/electrostrictive material. The filler is made of a material (the low thermal expansion material) having a thermal expansion coefficient smaller than that of the alkali niobate-based piezoelectric/electrostrictive material. Therefore, in the piezoelectric/electrostrictive ceramics sintered body according to the present invention, a compressive stress is introduced in the grains (in-grain) constituting the matrix, and high electric characteristics (electric-field-induced strain, a relative dielectric constant, a piezoelectric constant, a dielectric loss, etc.) are indicated.

### BRIEF DESCRIPTION OF THE DRAWINGS

Fig. 1 shows Raman spectrum of the crushed powder of a sintered body prepared Comparative Example 1;
Fig. 2 is a schematic diagram showing the state of the section of a piezoelectric/electrostrictive ceramics sintered body according to the present invention;
Fig. 3 is a photograph showing the mapping of the spectrum wave number of the ν1 symmetric stretching mode of an alkali niobate-based piezoelectric/electrostrictive material of a matrix of a piezoelectric/electrostrictive ceramics sintered body of Example 2; and
Fig. 4 is a sectional view schematically showing one embodiment of a piezoelectric/electrostrictive device according to the present invention.

### Description of Reference Numerals

1: substrate, 2: piezoelectric/electrostrictive body, 4, 5: electrode, 10: piezoelectric/electrostrictive device, 20: matrix, 30: filler, and 50: piezoelectric/electrostrictive ceramics sintered body.

### DESCRIPTION OF THE PREFERRED EMBODIMENT

The embodiments for carrying out the present invention are described below. However, the present invention is not restricted to the following embodiments and it should be construed that there are also included, in the present invention, those embodiments in which appropriate changes, improvements, etc. have been made to the following embodiments based on the ordinary knowledge possessed by those skilled in the art, as long as there is no deviation from the gist of the present invention.

First, the details of the alkali niobate-based piezoelectric/electrostrictive ceramics sintered body according to the present invention will be described. The piezoelectric/electrostrictive ceramics sintered body according to the present invention is a composite sintered body constituted of the matrix and the filler. The matrix is made of the alkali niobate-based piezoelectric/electrostrictive material, and the filler is made of the low thermal expansion material having a thermal expansion coefficient smaller than that of the alkali niobate-based piezoelectric/electrostrictive material.

For example, as the material of the matrix, the alkali niobate-based piezoelectric/electrostrictive material is used, and as the material of the filler, the material (the low thermal expansion material) having the thermal expansion coefficient smaller than that of the alkali niobate-based piezoelectric/electrostrictive material is used. These matrix and filler materials are mixed at a predetermined volume ratio, and fired to be composite, whereby the piezoelectric/electrostrictive ceramics sintered body according to the present invention can be manufactured. In a large number of grains made of the alkali niobate-based piezoelectric/electrostrictive material constituting the matrix of the piezoelectric/electrostrictive ceramics sintered body, a compressive stress is introduced. In consequence, in Raman spectrum of the ν1 symmetric stretching mode of the alkali niobate-based piezoelectric/electrostrictive material, as compared with grain boundaries, the spectrum wave number shifts to high wave side with exceeding 3 cm⁻¹ in grains.

Thus, when the compressive stress is introduced into a large number of grains made of the alkali niobate-based piezoelectric/electrostrictive material constituting the matrix, the piezoelectric/electrostrictive ceramics sintered body which develops remarkably high electric characteristics can be obtained. Therefore, it can be considered that the spectrum wave number of the ν1 symmetric stretching mode of the Raman spectrum measured by Raman spectroscopy is an index or an item for obtaining the piezoelectric/electrostrictive ceramics sintered body having high electric characteristics.

It is to be noted that in the present invention, the low thermal expansion material of the filler does not include any alkali niobate-based material. This "alkali niobate-based material" is a material having a composition equal to or different from that of the alkali niobate-based piezoelectric/electrostrictive material of the matrix. That is, the filler is made of the low thermal expansion material which substantially does not indicate any piezoelectric/electrostrictive characteristics.

Next, one example of a method for manufacturing the piezoelectric/electrostrictive ceramics sintered body according to the present invention will be described. First, matrix material powder and filler material powder are prepared, respectively.

The matrix material powder is calcinated/crushed powder including an alkali niobate-based perovskite type oxide as a main crystal phase. To prepare the matrix material powder, first a compound containing metal elements is weighed so as to satisfy the ratio (the molar ratio) of the respective metal elements in the composition of the perovskite type oxide, and mixed with a solvent such as ethanol by a mixing method such as ball milling, to obtain a mixed slurry. As the compound containing the respective metal elements, the oxide, carbonate, tartrate or the like of the metal elements is preferably used. Specifically, lithium carbonate, potassium bitartrate, sodium bitartrate, niobium oxide or tantalum oxide may be used.

Next, the resultant mixed slurry is dried by use of a drier or by a filter operation or the like, calcinated and crushed, whereby the matrix material powder (the calcinated/crushed powder) can be obtained. The crushing may be performed by a method such as ball milling. The calcinated and crushed matrix material powder has an average grain diameter of preferably 0.1 µm or more and 1 µm or less. It is to be noted that "the average grain diameter" mentioned herein is a 50% diameter (the median diameter) in a cumulative distribution.

The filler material powder can be prepared in conformity to the above method for preparing the matrix material powder. To manufacture the piezoelectric/electrostrictive ceramics sintered body indicating high piezoelectric characteristics, the sintered body obtained by firing the filler material powder needs to have a thermal expansion coefficient smaller than that of the sintered body obtained by firing the matrix material powder. Therefore, as the material of the filler, for example, at least one selected from the group consisting of molybdenum oxide, niobium oxide, tin oxide, tungsten oxide and aluminum oxide can preferably be used.

The average grain diameter of the filler material powder is preferably 0.5 µm or more and 10 µm or less, further preferably 1 µm or more and 5 µm or less. When the average grain diameter of the filler material powder is below 0.5 µm, the filler material powder easily reacts (dissolves) with the matrix material powder, and the crystal phase or composition of the resultant piezoelectric/electrostrictive ceramics sintered body becomes uniform or nearly uniform (i.e., does not have any composite structure) on occasion. On the other hand, when the average grain diameter of the filler material powder exceeds 10 µm, it becomes difficult to fire the powder sometimes, and the density of the resultant piezoelectric/electrostrictive ceramics sintered body tends to lower.

The filler material powder is added to the matrix material powder, mixed, formed into pellets and fired so that the volume fraction of the filler of the composite sintered body of the matrix and the filler (the piezoelectric/electrostrictive ceramics sintered body) is 0.5 vol% or more and below 10 vol%.

The firing is preferably performed in an oxygen atmosphere by a two-step firing method including a first step of firing (holding) the powder at a high temperature and a second step of firing (holding) the powder at a temperature lower than that of the first step. When the powder is fired by such a two-step firing method, it is possible to obtain the sufficiently dense piezoelectric/electrostrictive ceramics sintered body having a high relative density.

The first step preferably has a heating rate: ≥ 300°C/hour, a holding temperature: 1000 to 1200°C and a holding time: 0.1 to 5 minutes, and further preferably has a heating rate: ≥ 500°C/hour, a holding temperature: 1000 to 1100°C and a holding time: 0.5 to 2 minutes. Moreover, the second step, continuously from the first step, preferably has a cooling rate: 300 to 2000°C/hour, a holding temperature: 700 to 1000°C and a holding time: 0.5 to 30 hours, and further preferably has a cooling rate: ≥ 600°C/hour, a holding temperature: 800 to 990°C and a holding time: 1 to 15 hours.

After the firing, the body is worked into an appropriate shape (e.g., a strip-like shape) if necessary, and further subjected to a polarization treatment, whereby the piezoelectric/electrostrictive ceramics sintered body according to the present invention can be obtained. It is to be noted that the polarization treatment may usually be performed by applying a voltage of about 5 kV/mm for 15 minutes or more.

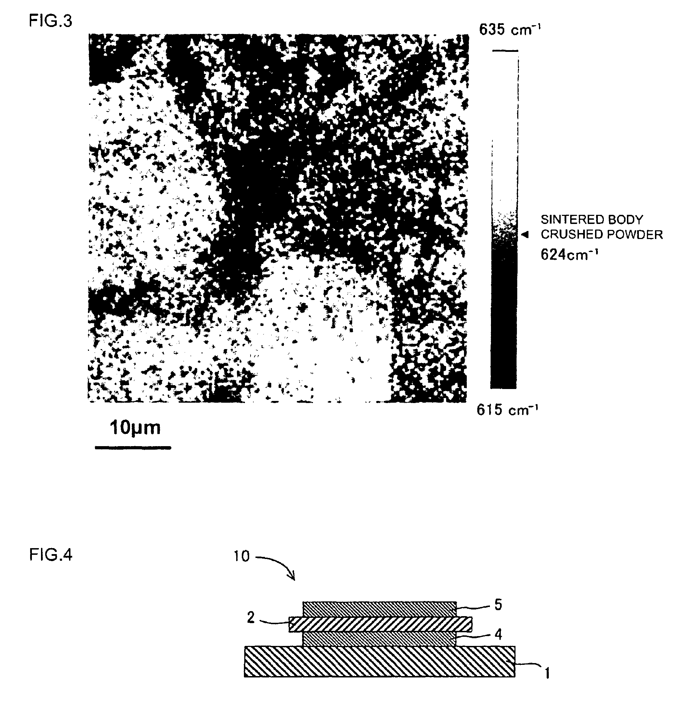

Next, the details of a piezoelectric/electrostrictive device according to the present invention will be described with reference to the drawings. Fig. 4 is a sectional view schematically showing one embodiment of the piezoelectric/electrostrictive device of the present invention. As shown in Fig. 4, a piezoelectric/electrostrictive device 10 of the present embodiment has a constitution in which a substrate 1 made of, for example, zirconia, a film-like piezoelectric/electrostrictive body 2 and a pair of film-like electrodes 4, 5 provided so as to sandwich this piezoelectric/electrostrictive body 2 therebetween are laminated. The piezoelectric/electrostrictive body 2 of the piezoelectric/electrostrictive device 10 of the present embodiment is the above-mentioned piezoelectric/electrostrictive ceramics sintered body. It is to be noted that Fig. 4 shows the piezoelectric/electrostrictive device 10 including the piezoelectric/electrostrictive body 2 of one layer, but the piezoelectric/electrostrictive body is not limited to the single layer, and is preferably multilayered.

The piezoelectric/electrostrictive body 2 is secured onto the substrate 1 while the electrode 4 is interposed between the body and the substrate. The piezoelectric/electrostrictive body 2 and the substrate 1 is preferably densified, integrated and secured by a solid phase reaction between the piezoelectric/electrostrictive body 2 and the substrate 1 without using any adhesive or the like.

The piezoelectric/electrostrictive body 2 of the piezoelectric/electrostrictive device 10 has a thickness of preferably 0.5 to 50 µm, further preferably 0.8 to 40 µm, especially preferably 1.0 to 30 µm. When the thickness of the piezoelectric/electrostrictive body 2 is below 0.5 µm, the densifying of the piezoelectric/electrostrictive body 2 becomes insufficient on occasion. On the other hand, when the thickness of the piezoelectric/electrostrictive body 2 exceeds 50 µm, the contraction stress of the piezoelectric/electrostrictive body 2 during the firing increases, and the substrate 1 needs to be thickened in order to prevent the breakdown of the substrate 1, whereby it becomes difficult to miniaturize the piezoelectric/electrostrictive device on occasion.

The substrate 1 has a thickness of preferably 1 µm to 1 mm, further preferably 1.5 to 500 µm, especially preferably 2 to 200 µm. When the thickness of the substrate 1 is below 1 µm, the mechanical strength of the piezoelectric/electrostrictive device 10 decreases on occasion. On the other hand, when the thickness of the substrate 1 exceeds 1 mm, against the contraction stress generated when the electric field is applied to the piezoelectric/electrostrictive body 2, the rigidity of the substrate 1 might increase, and the flexural displacement of the piezoelectric/electrostrictive body 2 might decrease.

### Examples

Hereinafter, the present invention will be described in more detail with respect to examples, but the present invention is not limited to these examples.

### [Raman Spectrometry]

Raman spectrometry performed in the following examples will be described. To perform the Raman spectrometry, a Raman spectroscopic instrument was used in which a laser having an excitation wavelength of 532 nm was mounted. A sample worked into a strip-like shape was used as an analysis target for evaluating electric characteristics. In addition, to obtain data when any stress is free, crushed powder which was obtained by crushing a sintered body was used as the analysis target. In case of the crushed powder, to remove stress induced during crushing, a heat treatment was performed in the atmosphere at 600 to 900°C for one hour before analysis. To remove working strain from the sample worked into the strip-like shape, the cross-section of the sample was polished by a cross-section polishing (CP) method using Ar ions before the analysis. Moreover, the laser diameter of the Raman spectroscopic instrument was set to about 0.4 µm, and the mapping analysis of a spectrum wave number (an XY scanning step width: 0.4 µm) was performed. It is to be noted that a measurement temperature was room temperature.

### (Comparative Example 1)

Calcinated/crushed powder (grain diameters of 0.2 to 0.5 µm, a spherical grain shape) having a composition of [{Li_{y}(Na₁₋ₓKₓ)_{1-y}}₁₋ₜBiₜ]ₐ(Nb_{1-z}Ta_{z})O₃ (x = 0.450, y = 0.060, z = 0.082, a = 1.01, t = 0.0005)+0.05 mol%MnO₂ was formed into pellets, and a plurality of pellet-like samples were obtained. These pellet-like samples were heated to a firing temperature of 970°C at a heating rate of 200°C/hour in the atmosphere. After holding the samples at 970°C for three hours, the samples were cooled to room temperature at a cooling rate of 200°C/hour, and piezoelectric/electrostrictive ceramics sintered bodies were obtained. The density of the resultant piezoelectric/electrostrictive ceramics sintered bodies was 94 to 95%, and the thermal expansion coefficient was 7×10⁻⁶ (1/K).

Crushed powder obtained by crushing a part of the resultant piezoelectric/electrostrictive ceramics sintered body was subjected to a heat treatment, to remove stress induced during the crushing. The crushed powder after removing the stress was subjected to the Raman spectrometry, thereby obtaining Raman spectrum.

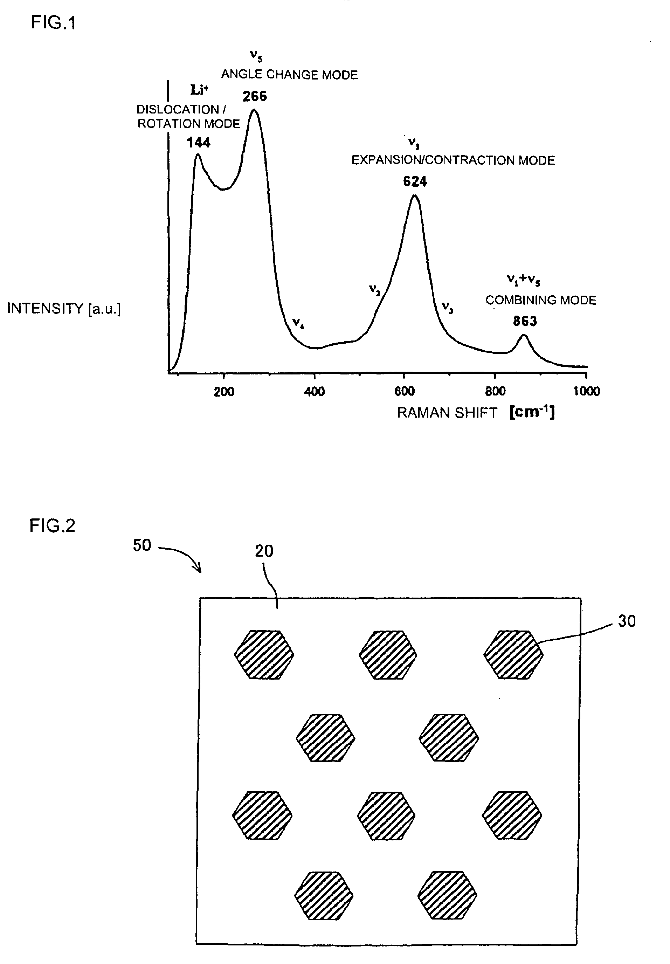

Fig. 1 shows the Raman spectrum of the crushed powder prepared in Comparative Example 1. In the same manner as "K. Kakimoto et. al., Jpn. J. Appl. Phys. Vol. 44 No.9B(2005)7064" (Non-Patent Document 5), four spectrums were mainly observed, and Li⁺ translational mode (around 144 cm⁻¹), v5 bending mode (around 266 cm⁻¹), ν1 symmetric stretching mode (around 624 cm⁻¹) and ν1+ν5 coupling mode (around 863 cm⁻¹) were classified. The Li⁺ translational mode and the v5 bending mode had the noticeable overlap of the spectrums, and the ν1+ν5 coupling mode had a spectrum in which two modes were originally overlapped. On the other hand, the ν1 symmetric stretching mode was a substantially single spectrum. Therefore, the ν1 symmetric stretching mode was used to obtain a spectrum shift maximum value and a high wave number region.

The strip-like sample obtained by working the resultant piezoelectric/electrostrictive ceramics sintered body was subjected to a heat treatment in the atmosphere at 600 to 900°C for one hour to remove a working stress. Afterward, the sample was subjected to a polarization treatment in silicon oil held at 25°C with a voltage of 5 kV/mm for 15 minutes, and electric-field-induced strain S4000 was measured. The electric-field-induced strain S4000 is a strain amount in 31 direction (directions vertical to an electric field applying direction) when an electric field of 4 kV/mm is applied.

After measuring the electric-field-induced strain S4000, the strip-like sample was cut, and the cross-section was polished by CP method to form a polished surface. The polished surface was subjected to Raman spectrometry, and the mapping of the spectrum wave number in the ν1 symmetric stretching mode was obtained. Based on the mapping, a spectrum shift maximum value and a high wave number region in the ν1 symmetric stretching mode were obtained. Results are shown in Tables 1 to 6 together with the electric-field-induced strain S4000.

### [Spectrum Shift Maximum Value]

In the tables, "the spectrum shift maximum value" is the maximum value of the difference of the spectrum wave number between grain boundary portions of a matrix portion (an alkali niobate-based piezoelectric/electrostrictive material including a perovskite type oxide as a main crystal phase) and in-grain portions thereof.

### [High Wave Number Region]

In the tables, "the high wave number region" is an area ratio of a region where the spectrum wave number of the matrix portion of the strip-like sample shifts to high wave number side with exceeding 3 cm⁻¹ as compared with the spectrum wave number of the crushed powder which was obtained by crushing the sintered body (the perovskite type oxide), with respect to the whole matrix.

### (Comparative Examples 2 and 3)

The same calcinated/crushed powder as that used in Comparative Example 1 (matrix material powder, grain diameters: 0.2 to 0.5 µm) was prepared, and MgO powder (filler material powder, grain diameters: 1 to 5 µm, a spherical grain shape) was prepared. It is to be noted that the thermal expansion coefficient of a filler sintered body obtained by firing this filler material powder was 1.5×10⁻⁵ (1/K). The filler material powder was added so that the volume fraction of the filler with respect to the whole composite sintered body of the matrix and the filler (the piezoelectric/electrostrictive ceramics sintered body) (with the proviso that pore portions were excluded) was 0.5 vol% (Comparative Example 2), 1.5 vol% (Comparative Example 3), followed by mixing. This mixture was formed into pellets, and a plurality of pellet-like samples were obtained. These pellet-like samples were heated to 1000 to 1100°C at a heating rate of 500 to 1000°C/hour in the atmosphere. After holding the samples for one to two minutes, the samples were cooled to 800 to 900°C at a cooling rate of 300 to 2000°C/hour, further held for three to 15 hours, and cooled to room temperature, whereby piezoelectric/electrostrictive ceramics sintered bodies were obtained. The density of the resultant piezoelectric/electrostrictive ceramics sintered bodies was 94 to 95%.

Next, in the same manner as in Comparative Example 1, crushed powder was obtained by crushing the piezoelectric/electrostrictive ceramics sintered body, and subjected to a heat treatment, to remove stress induced during crushing. Moreover, a strip-like sample obtained by working the piezoelectric/electrostrictive ceramics sintered body was subjected to a heat treatment and a polarization treatment, and then electric-field-induced strain S4000 was measured.

Then, in the same manner as in Comparative Example 1, the crushed powder and the polished surface of the strip-like sample were subjected to Raman spectrometry, and the mapping of spectrum wave numbers in ν1 symmetric stretching mode was obtained. Based on the mapping, a spectrum shift maximum value and a high wave number region in the ν1 symmetric stretching mode were obtained. Results are shown in Table 1 together with the volume fraction of MgO and the electric-field-induced strain S4000.

**[Table 1]**

| | Comp. Ex.1 | Comp. Ex. 2 | Comp. Ex. 3 |
|---|---|---|---|
| MgO [vol%] | None | 0.5 | 1.5 |
| Spectrum shift maximum value [cm⁻¹] | 3 | 3 | 3 |
| High wave number region [%] | 9 | 8 | 6 |
| S4000 [ppm] | 615 | 550 | 480 |

### (Examples 1 to 3 and Comparative Example 4)

The same calcinated/crushed powder as that used in Comparative Example 1 (matrix material powder, grain diameters: 0.2 to 0.5 µm) was prepared, and Mo₂O₃ powder (filler material powder, grain diameters: 1 to 5 µm, a spherical grain shape) was prepared. It is to be noted that the thermal expansion coefficient of a filler sintered body obtained by firing the filler material powder was 5×10⁻⁶ (1/K). The filler material powder was added so that the volume fraction of the filler with respect to the whole composite sintered body of the matrix and the filler (the piezoelectric/electrostrictive ceramics sintered body) (with the proviso that pore portions were excluded) was 0.5 vol% (Example 1), 1.5 vol% (Example 2), 5 vol% (Example 3), 10 vol% (Comparative Example 4), followed by mixing. This mixture was formed into pellets, and a plurality of pellet-like samples were obtained. These pellet-like samples were fired on conditions similar to those of Comparative Examples 2 and 3, and piezoelectric/electrostrictive ceramics sintered bodies were obtained. The density of the resultant sintered bodies was 94 to 95%.

Next, in the same manner as in Comparative Example 1, crushed powder was obtained by crushing the piezoelectric/electrostrictive ceramics sintered body, and subjected to a heat treatment, to remove stress induced during crushing. Moreover, a strip-like sample obtained by working the piezoelectric/electrostrictive ceramics sintered body was subjected to a heat treatment and a polarization treatment, and then electric-field-induced strain S4000 was measured.

Then, in the same manner as in Comparative Example 1, the crushed powder and the polished surface of the strip-like sample were subjected to Raman spectrometry, and the mapping of spectrum wave numbers in ν1 symmetric stretching mode was obtained. Based on the mapping, a spectrum shift maximum value and a high wave number region in the ν1 symmetric stretching mode were obtained. Results are shown in Table 2 together with the volume fraction of Mo₂O₃ and the electric-field-induced strain S4000.

**[Table 2]**

| | Comp. Ex. 1 | Ex.1 | Ex.2 | Ex.3 | Comp. Ex.4 |
|---|---|---|---|---|---|
| Mo₂O₃ [vol%] | None | 0.5 | 1.5 | 5 | 10 |
| Spectrum shift maximum value [cm⁻¹] | 3 | 6 | 20 | 5 | 5 |
| High wave number region [%] | 9 | 20 | 50 | 15 | 15 |
| S4000 [ppm] | 615 | 670 | 710 | 650 | 550 |

It is to be noted that Fig. 2 shows a schematic diagram showing the state of the cross-section of the piezoelectric/electrostrictive ceramics sintered body according to the present invention. Fig. 2 schematically shows a piezoelectric/electrostrictive ceramics sintered body 50 (the composite sintered body) constituted of a matrix 20, and a filler 30 made of a low thermal expansion material.

Moreover, Fig. 3 is a photograph showing the mapping of spectrum wave numbers in the ν1 symmetric stretching mode of an alkali niobate-based piezoelectric/electrostrictive material of a matrix of a piezoelectric/electrostrictive ceramics sintered body of Example 2. Around the spectrum wave number (624 cm⁻¹) of crushed powder which was obtained by crushing the sintered body, spectra shifted to low wave number side in the vicinity of grain boundaries, and shifted to high wave number side in grains, respectively. According to the literature by "A. Suchocki et. al., Appl. Phys. Lett. 89(2006)261908" (Non-Patent Document 6), it is reported that the spectrum in the ν1 symmetric stretching mode of LiNbO₃ shifts to the high wave number side when compressive stress is induced. Based on this discussion, it can be judged that the compressive stress is induced into the grains of the matrix portion of the alkali niobate-based piezoelectric/electrostrictive material.

### (Examples 4 to 6 and Comparative Example 5)

Piezoelectric/electrostrictive ceramics sintered bodies (Examples 4 to 6, Comparative Example 5) were obtained in the same manner as in Examples 1 to 3 and Comparative Example 4 described above, except that Nb₂O₅ powder (grain diameters: 1 to 5 µm, a spherical grain shape) was used as filler material powder. It is to be noted that the thermal expansion coefficient of a filler sintered body obtained by firing the filler material powder was 2×10⁻⁶ (1/K). The measurement results of various physical values of the resultant piezoelectric/electrostrictive ceramics sintered bodies are shown in Table 3.

**[Table 3]**

| | Comp. Ex. 1 | Ex.4 | Ex.5 | Ex.6 | Comp. Ex. 5 |
|---|---|---|---|---|---|
| Nb₂O₅ [vol%] | None | 0.5 | 1.5 | 5 | 10 |
| Spectrum shift maximum value [cm⁻¹] | 3 | 4 | 6 | 3 | 2 |
| High wave number region [%] | 9 | 16 | 18 | 10 | 8 |
| S4000[ppm] | 615 | 640 | 650 | 630 | 590 |

### (Examples 7 to 9 and Comparative Example 6)

Piezoelectric/electrostrictive ceramics sintered bodies (Examples 7 to 9, Comparative Example 6) were obtained in the same manner as in Examples 1 to 3 and Comparative Example 4 described above, except that SnO₂ powder (grain diameters: 1 to 5 µm, a spherical grain shape) was used as filler material powder. It is to be noted that the thermal expansion coefficient of a filler sintered body obtained by firing the filler material powder was 4×10⁻⁶ (1/K). The measurement results of various physical values of the resultant piezoelectric/electrostrictive ceramics sintered bodies are shown in Table 4.

**[Table 4]**

| | Comp. Ex.1 | Ex.7 | Ex.8 | Ex.9 | Comp. Ex. 6 |
|---|---|---|---|---|---|
| SnO₂ [vol%] | None | 0.5 | 1.5 | 5 | 10 |
| Spectrum shift maximum value [cm⁻¹] | 3 | 6 | 6 | 3 | 2 |
| High wave number region [%] | 9 | 15 | 20 | 10 | 8 |
| S4000 [ppm] | 615 | 650 | 670 | 630 | 570 |

### (Examples 10 to 12 and Comparative Example 7)

Piezoelectric/electrostrictive ceramics sintered bodies (Examples 10 to 12, Comparative Example 7) were obtained in the same manner as in Examples 1 to 3 and Comparative Example 4 described above, except that WO₂ powder (grain diameters: 1 to 5 µm, a spherical grain shape) was used as filler material powder. It is to be noted that the thermal expansion coefficient of a filler sintered body obtained by firing the filler material powder was 4×10⁻⁶ (1/K). The measurement results of various physical values of the resultant piezoelectric/electrostrictive ceramics sintered bodies are shown in Table 5.

**[Table 5]**

| | Comp. Ex.1 | Ex.10 | Ex.11 | Ex.12 | Comp. Ex. 7 |
|---|---|---|---|---|---|
| WO₂ [vol%] | None | 0.5 | 1.5 | 5 | 10 |
| Spectrum shift maximum value [cm⁻¹] | 3 | 4 | 6 | 3 | 2 |
| High wave number region [%] | 9 | 16 | 17 | 10 | 7 |
| S4000 [ppm] | 615 | 640 | 660 | 630 | 550 |

### (Examples 13 to 15 and Comparative Example 8)

Piezoelectric/electrostrictive ceramics sintered bodies (Examples 13 to 15, Comparative Example 8) were obtained in the same manner as in Examples 1 to 3 and Comparative Example 4 described above, except that Al₂O₃ powder (grain diameters: 1 to 5 µm, a spherical grain shape) was used as filler material powder. It is to be noted that the thermal expansion coefficient of a filler sintered body obtained by firing the filler material powder was 5×10⁻⁶ (1/K). The measurement results of various physical values of the resultant piezoelectric/electrostrictive ceramics sintered bodies are shown in Table 6.

**[Table 6]**

| | Comp. Ex. 1 | Ex.13 | Ex.14 | Ex.15 | Comp. Ex.8 |
|---|---|---|---|---|---|
| Al₂O₃ [vol%] | None | 0.5 | 1.5 | 5 | 10 |
| Spectrum shift maximum value [cm⁻¹] | 3 | 3 | 6 | 3 | 2 |
| High wave number region [%] | 9 | 10 | 15 | 10 | 5 |
| S4000 [ppm] | 615 | 630 | 650 | 630 | 550 |

### (Comparative Example 9)

Calcinated/crushed powder (grain diameters of 0.2 to 0.5 µm, a spherical grain shape) having a composition of {Li_{y}(Na₁₋ₓKₓ)_{1-y}}ₐ(Nb_{1-z-w}Ta_{z}Sb_{w})O₃ (x = 0.360, y = 0.070, z = 0.082, a = 1.01, W = 0.040)+0.02 mol%MnO₂ was formed into pellets, and a plurality of pellet-like samples were obtained. These pellet-like samples were heated to a firing temperature of 970°C at a heating rate of 200°C/hour in the atmosphere. After holding the samples at 970°C for three hours, the samples were cooled to room temperature at a cooling rate of 200°C/hour, and piezoelectric/electrostrictive ceramics sintered bodies were obtained. The density of the resultant piezoelectric/electrostrictive ceramics sintered bodies was 94 to 95%, and the thermal expansion coefficient was 6.2×10⁻⁶(1/K).

Next, in the same manner as in Comparative Example 1, crushed powder was obtained by crushing the piezoelectric/electrostrictive ceramics sintered body, and subjected to a heat treatment, to remove stress induced during the crushing. Moreover, a strip-like sample obtained by working the piezoelectric/electrostrictive ceramics sintered body was subjected to a heat treatment and a polarization treatment, and electric-field-induced strain S4000 was measured.

Then, in the same manner as in Comparative Example 1, the crushed powder and the polished surface of the strip-like sample were subjected to Raman spectrometry, and the mapping of spectrum wave numbers in ν1 symmetric stretching mode was obtained. Based on the mapping, a spectrum shift maximum value and a high wave number region in the ν1 symmetric stretching mode were obtained. Results are shown in Table 7 together with the electric-field-induced strain S4000.

### (Examples 16 to 18 and Comparative Example 10)

The same calcinated/crushed powder as that used in Comparative Example 9 (matrix material powder, grain diameters: 0.2 to 0.5 µm) was prepared, and Mo₂O₃ powder (filler material powder, grain diameters: 1 to 5 µm, a spherical grain shape) was prepared. It is to be noted that the thermal expansion coefficient of a filler sintered body obtained by firing the filler material powder was 5×10⁻⁶ (1/K). The filler material powder was added so that the volume fraction of the filler with respect to the whole composite sintered body of a matrix and a filler (the piezoelectric/electrostrictive ceramics sintered body) (with the proviso that pore portions were excluded) was 0.5 vol% (Example 16), 1.5 vol% (Example 17), 5 vol% (Example 18), 10 vol% (Comparative Example 10), followed by mixing. This mixture was formed into pellets, and a plurality of pellet-like samples were obtained. These pellet-like samples were heated to 1000 to 1100°C at a heating rate of 500 to 1000°C/hour in the atmosphere. After holding the samples for one to two minutes, the samples were cooled to 850 to 990°C at a cooling rate of 300 to 2000°C/hour, further held for one to 15 hours, and cooled to room temperature, whereby piezoelectric/electrostrictive ceramics sintered bodies were obtained. The density of the resultant piezoelectric/electrostrictive ceramics sintered bodies was 94 to 95%.

Next, in the same manner as in Comparative Example 1, crushed powder was obtained by crushing the piezoelectric/electrostrictive ceramics sintered body, and subjected to a heat treatment, to remove stress induced during crushing. Moreover, a strip-like sample obtained by working the piezoelectric/electrostrictive ceramics sintered body was subjected to a heat treatment and a polarization treatment, and then electric-field-induced strain S4000 was measured.

Then, in the same manner as in Comparative Example 1, the crushed powder and the polished surface of the strip-like sample were subjected to Raman spectrometry, and the mapping of spectrum wave numbers in ν1 symmetric stretching mode was obtained. Based on the mapping, a spectrum shift maximum value and a high wave number region in the ν1 symmetric stretching mode were obtained. Results are shown in Table 7 together with the volume fraction of Mo₂O₃ and the electric-field-induced strain S4000.

**[Table 7]**

| | Comp. Ex. 9 | Ex.16 | Ex.17 | Ex.18 | Comp. Ex.10 |
|---|---|---|---|---|---|
| Mo₂O₃ [vol%] | None | 0.5 | 1.5 | 5 | 10 |
| Spectrum shift maximum value [cm⁻¹] | 2 | 6 | 20 | 5 | 5 |
| High wave number region [%] | 9 | 21 | 50 | 17 | 15 |
| S4000[ppm] | 620 | 690 | 740 | 680 | 520 |

### (Considerations)

It is seen from the results of Examples 1 to 18 and Comparative Examples 1 to 10 that piezoelectric/electrostrictive ceramics sintered bodies as composite sintered bodies are as follows. In piezoelectric/electrostrictive ceramics sintered bodies (Comparative Examples 2 and 3) as composite sintered bodies in which a high thermal expansion material was used as a filler, electric characteristics lowered as compared with an alkali niobate-based piezoelectric/electrostrictive ceramics sintered body (Comparative Example 1) which was not composite. On the other hand, in piezoelectric/electrostrictive ceramics sintered bodies (Examples 1 to 18) as composite sintered bodies in which low thermal expansion materials were used as fillers, electric characteristics improved as compared with alkali niobate-based piezoelectric/electrostrictive ceramics sintered bodies (Comparative Examples 1 and 9) which were not composite. This is supposedly because when the low thermal expansion materials were used as the fillers, compressive stress was induced into grains of matrixes made of alkali niobate-based piezoelectric/electrostrictive materials in a cooling process after firing.

It has been confirmed that in a piezoelectric/electrostrictive ceramics sintered body which had a large spectrum shift maximum value and a large high wave number, that is, into which larger compressive stress was induced, electric characteristics were high. However, it has been found that when the volume fraction of the filler is 10 vol% or more (Comparative Examples 4 to 8 and 10), the compressive stress is induced, but the electric characteristics lower. This is supposedly because the relative content of the alkali niobate-based piezoelectric/electrostrictive material which develops piezoelectric characteristics decreases.

A piezoelectric/electrostrictive ceramics sintered body according to the present invention has an excellent electric-field-induced strain, and is preferably used as a material of a piezoelectric/electrostrictive device (a piezoelectric/electrostrictive body) constituting an actuator, a sensor or the like.

## Claims

1. A piezoelectric/electrostrictive ceramics sintered body comprising a matrix and a filler and having a structure in which the matrix and the filler are brought into a composite,
wherein the matrix is made of an alkali niobate-based piezoelectric/electrostrictive material, which includes a large number of grains combined with one another, including a perovskite type oxide, which includes at least one element selected from the group consisting of Li, Na and K as an A site constituent element and Nb as a B site constituent element, as a main crystal phase,
the filler is made of a material (with the proviso that an alkali niobate-based material is excluded) having a thermal expansion coefficient smaller than that of the alkali niobate-based piezoelectric/electrostrictive material, and
the volume fraction of the filler with respect to the total volume of the matrix and the filler is 0.5 vol% or more and below 10 vol%.

2. The piezoelectric/electrostrictive ceramics sintered body according to claim 1,
wherein the perovskite type oxide further includes at least one of Ta and Sb as the B site constituent element.

3. The piezoelectric/electrostrictive ceramics sintered body according to claim 1 or 2,
wherein in Raman spectrum of the ν1 symmetric stretching mode of the alkali niobate-based piezoelectric/electrostrictive material obtained when the matrix is subjected to Raman spectrometry, a spectrum wave number shifts to a high wave side with exceeding 3 cm⁻¹ in grains as compared with grain boundaries.

4. The piezoelectric/electrostrictive ceramics sintered body according to claim 3,
wherein as compared with the grain boundaries, a region in the grains in which the spectrum wave number shifts to the high wave side with exceeding 3 cm⁻¹ is present as much as 10% or more and 50% or less in terms of area.

5. The piezoelectric/electrostrictive ceramics sintered body according to any one of claims 1 to 4,
wherein the material of the filler is at least one selected from the group consisting of molybdenum oxide, niobium oxide, tin oxide, tungsten oxide and aluminum oxide.

6. A piezoelectric/electrostrictive device comprising:
a film-like piezoelectric/electrostrictive body made of the piezoelectric/electrostrictive ceramics sintered body according to any one of claims 1 to 5;
a pair of electrodes arranged so as to sandwich the piezoelectric/electrostrictive body therebetween; and
a substrate joined to one of the surfaces of the pair of electrodes.

7. The piezoelectric/electrostrictive device according to claim 6,
wherein the material of the substrate is zirconium oxide or a metal.
